# EUROPEAN PATENT APPLICATION

(11) **EP 3 591 697 A1**
(43) Date of publication of application: **08.01.2020**
(21) Application number: 17903131.5
(22) Date of filing: 21.06.2017
(51) Int. Cl.: H01L 25/075, H01L 33/62, G09F 9/33

(54) **QFN SURFACE-MOUNTED RGB-LED PACKAGING MODULE AND MANUFACTURING METHOD THEREFOR**

(30) Priority: 28.03.2017 CN 201710194274
(71) Applicant: Shandong Prosperous Star Optoelectronics Co., Ltd, Tai'an, Shandong 271200 (CN)
(72) Inventor: LI, Shaoli, Tai'an Shandong 271200 (CN); KONG, Yiping, Tai'an Shandong 271200 (CN); YUAN, Xincheng, Tai'an Shandong 271200 (CN)
(74) Representative: Cabinet Chaillot
(86) International application number: PCT/CN2017/089335
(87) International publication number: WO 2018/176656

(57) **Abstract**

The present invention provides a QFN surface-mounted RGB LED packaging module and a preparing method thereof, which comprises a packaging holder and light emitting units arranged on the packaging holder, the packaging holder comprises a metal baseboard and an insulating frame, holder electrodes for die bond and wire weld are arranged on the metal baseboard at regions where each light emitting unit is located, each light emitting unit comprises RGB LED chips fixed on the metal baseboard as well as keys and wires for connecting the RGB LED chips with the holder electrodes, a protective layer is arranged on the light emitting units, and the holder electrodes are connected with an external circuit by pads arranged on the back of the metal baseboard, so that the light emitting surface is unique; and the plurality of light emitting units is integrated on one packaging module to further improve the production efficiency.

## Description

### Technical Field

The present invention relates to an SMD (Surface Mounted Devices) LED packaging technology, and more particularly relates to a QFN (Quad Flat No-lead Package) surface-mounted RGB LED packaging module and a preparing method thereof.

### Background Art

With continuous development of the display screen industry, LEDs for display screens are rapidly transept from original DIP (dual inline-pin package) structures to SMD structures. The LEDs of the SMD structures have been increasingly accepted by users due to the advantages of light weight, smaller size, automatic installation, large illumination angle, uniform color, little attenuation and the like. Although the general SMD LEDs have the above advantages, however, problems of large attenuation, long heat conduction path, low carrying current, complicated production, low reliability, low moisture resistance, poor weather resistance and the like still exist. If the reliability of a product is to be improved without changing the overall structure of the product, there is still no good solution in the industry.

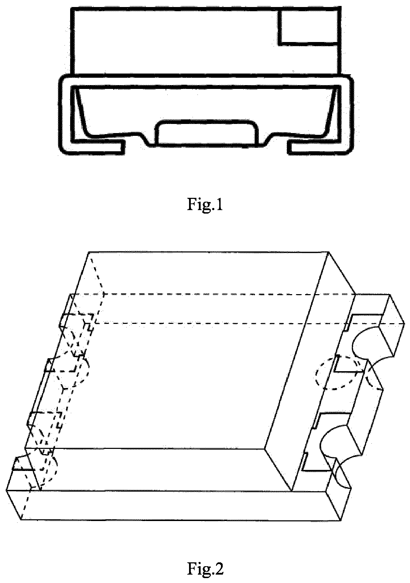

Packaging devices of 2121, 1515, 1010, 0808 and other types are mainly used in the existing small-pitch display screens. With the reduction of pixel pitches of LED display screens, more and more packaging devices are on per unit area, so that the proportion of the cost of the packaging devices in the cost of the whole screen is on the rise. By estimation, the proportion of the cost of the packaging devices has reached 70% or above in small-pitch LED display screens P1.9 and smaller-pitch products. If the density is increased by one level, the increase in bead demand is about 50%, that is, the production capacity of all bead manufacturers needs to increase by 50% or above. At present, full-color beads used for small pitches are mainly in a single form (as shown in Figure 1 and Figure 2). Due to the large number of beads in applications, the production efficiency is low, and quality problems are easily caused. For the single-mount problem, the production efficiency is improved to certain extent by using a COB (chip on board) integrated module. However, the COB integrated module also has many problems, such as color development difference and poor entire screen consistency caused by center value differences of different batches of chips or substrate ink differences. On the other hand, the chip directly mounted on the circuit board is not well protected such that the reliability cannot be guaranteed, and the failure maintenance cost of the light emitting unit is high.

Therefore, the prior art has yet to be improved and developed.

### Summary of the Invention

The present invention is directed to provide a QFN surface-mounted RGB LED packaging module and a preparing method thereof, aiming at solving the problems of low production efficiency of single mount of the existing mounted RGB LEDs, poor mechanical strength of packages and the like.

To solve the above problems, the technical scheme of the present invention is as follows:
A QFN surface-mounted RGB LED packaging module, comprising a packaging holder and light emitting units arranged on the packaging holder; the number of the light emitting units is at least two, and the packaging holder comprises a metal baseboard and an insulating frame; holder electrodes for die bond and wire weld are arranged on the metal baseboard at regions where each light emitting unit is located; each light emitting unit comprises RGB LED chips fixed on the metal baseboard as well as keys and wires for connecting the RGB LED chips with the holder electrodes; a protective layer is arranged on the light emitting units, and the holder electrodes are connected with an external circuit by pads arranged on the back of the metal baseboard.

The QFN surface-mounted RGB LED packaging module, wherein the insulating frame are arranged around the light emitting units and forms bowl shape.

The QFN surface-mounted RGB LED packaging module, wherein steps are set on the front side and/or the reverse side of the metal baseboard.

The QFN surface-mounted RGB LED packaging module, wherein support regions, being flush with the pads in height, are further set on the metal baseboard.

The QFN surface-mounted RGB LED packaging module, wherein the surface of the protective layer is rough and non-reflective.

A method for preparing the QFN surface-mounted RGB LED packaging module, comprising the following steps:
step 1: making a metal baseboard into conductive circuits;
step 2: coating glue on the metal baseboard, and leaving blank holder electrodes for die bond and wire weld to form a packaging holder;
step 3: plating a metal on the holder electrodes;
step 4: die-bonding RGB LED chips onto the holder electrodes, and welding wires to form a physical electrical connection;
step 5: forming a protective layer on light emitting units by injection molding; and
step 6: cutting into single packaging modules.

The method for preparing the QFN surface-mounted RGB LED packaging module, wherein step 1 further comprises setting steps on the front side and/or the reverse side of the metal baseboard.

The method for preparing the QFN surface-mounted RGB LED packaging module, wherein step 1 further comprises setting support regions, being flush with pads in height, on the back of the metal baseboard.

The method for preparing the QFN surface-mounted RGB LED packaging module, wherein step 2 comprises forming a plurality of bowls on the metal baseboard during die pressing.

The method for preparing the QFN surface-mount RGB LED packaging module, wherein the injection-molding method of the protective layer in step 5 comprises: injecting glue into bowl cavities by dispensing or filling, and then curing the glue by heating; or pressing the glue into the bowl cavities through an MGP mold, the glue being liquid glue or solid glue cakes.

The QFN surface-mounted RGB LED packaging module and the preparing method thereof according to the present invention have the beneficial effects: the metal baseboard is used to replace conventional plated thin metal, thereby enhancing the conductivity; the metal baseboard is directly in contact with a PCB, so the heat dissipation path is short, and the heat of the chips can be quickly exported; light is concentrated by setting the bowl-type structures on the front side, so that the light emitting surface is unique, and the resolution, light-dark contrast and the like of a manufactured display screen are superior; the steps are set on the metal baseboard to ensure a tight combination with the insulating frame and the stability of the packaging holder; and the plurality of light emitting units is integrated on one packaging module to further improve the production efficiency and reduce the production cost. In addition, the plurality of light emitting units is integrated on one module, which can effectively improve the overall resistance of the display screen to external mechanical strength; compared with the existing integrated module, one template of the present invention includes fewer light emitting units, which can effectively avoid the problems of color development difference and poor entire screen consistency caused by center value differences of different batches of chips or substrate ink differences; and the existing integrated module is high in maintenance cost if some light emitting units fail, but the present invention is low in maintenance cost.

### Brief Description of the Drawings

Figure 1 is a structure diagram of a conventional PPA holder.
Figure 2 is a structure diagram of a conventional CHIP type packaging holder.
Figure 3 is a front structure diagram of a QFN surface-mounted RGB LED packaging module according to the present invention.
Figure 4 is a cross-sectional view of the QFN surface-mounted RGB LED packaging module according to the present invention.
Figure 5 is a reverse structure diagram of the QFN surface-mounted RGB LED packaging module according to the present invention.
Figure 6 is a front structure diagram of a 1×2 QFN surface-mounted RGB LED packaging module according to the present invention.
Figure 7 is a front structure diagram of a 1×3 QFN surface-mounted RGB LED packaging module according to the present invention.
Figure 8 is a front structure diagram of a 1×3 QFN surface-mounted RGB LED packaging module according to the present invention.
Figure 9 is a front structure diagram of a 1×9 QFN surface-mounted RGB LED packaging module according to the present invention.
Figure 10 is a preparing flow diagram of a QFN surface-mounted RGB LED packaging module according to the present invention.
Figure 11 is a front structure diagram of a metal baseboard of a 1×4 QFN surface-mounted RGB LED packaging module according to the present invention.
Figure 12 is a reverse structure diagram of a metal baseboard of the 1×4 QFN surface-mounted RGB LED packaging module according to the present invention.
Figure 13 is a front structure diagram of a non-cut metal baseboard of the 1×4 QFN surface-mounted RGB LED packaging module according to the present invention.

Indication for drawing reference: 100. metal baseboard; 101. holder electrode; 102. pad; 103. step; 104. support region; 200. insulating frame; 201. bowl; 301. RGB LED chip; 302. key and wire; 400. protective layer; 701. thermoplastic material; 702. metal; 801. resin; 802. flat glue.

### Detailed Description of the Invention

For making objectives, technical schemes and advantages of the present invention clearer, the following further describes the present invention in detail with reference to the accompanying drawings and embodiments.

Figure 1 is a structure diagram of a conventional PPA+ copper lead packaging holder. Since a thermoplastic material in this type of packaging holder is tightly attached to the metal by an injection molding machine but not bonded to the metal, a gap is easily set between the two during thermal expansion and cold contraction. When a final customer uses the product, outside water and water vapor easily enter the package through the gap, causing product failure. Figure 2 is a structure diagram of a conventional CHIP type packaging holder, which is obtained by surrounding and compacting glass fibers with resin 801, and then etching circuits with copper and platinum, where the gap and moisture absorption rate of the materials are high, and the expansion rates of the materials are different. A layer of flat glue 802 is die-pressed on a plane as a protective layer in the later stage. A cup-shaped protection cannot be set in this way, and many problems will be caused. On the other hand, the products shown in Figure 1 and Figure 2 are in a single form, and the production efficiency is extremely low when being mounted later.

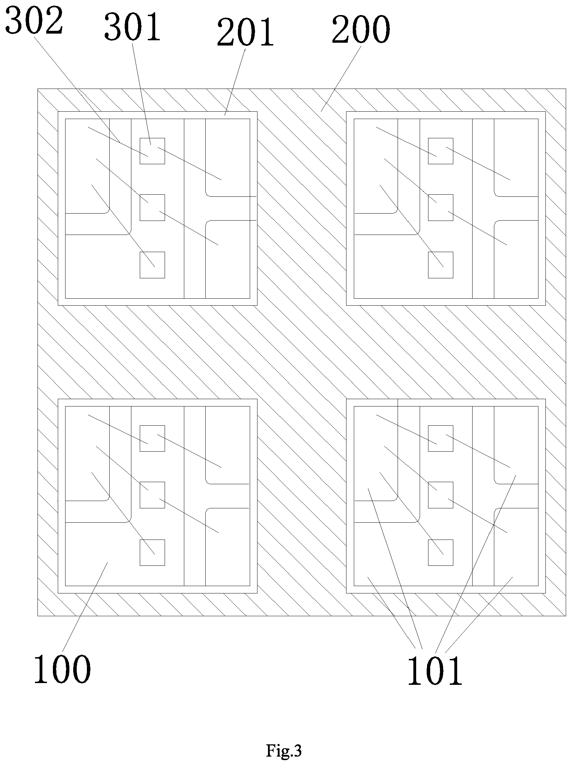

Referring to Figure 3 to Figure 5, a QFN surface-mounted RGB LED packaging module according to the present invention includes a packaging holder and light emitting units arranged on the packaging holder. The number of the light emitting units is at least two. Preferably, the number of the light emitting units is 2 to 1000. In the present embodiment, the number of the light emitting units is 4. The packaging holder includes a metal baseboard 100 and an insulating frame 200. In practical applications, the material of the metal baseboard 100 may be copper or iron. Preferably, the surface of the metal baseboard is plated with gold or silver to enhance the conductivity and facilitate welding. The material of the insulating frame may be epoxy resin, PPA, PCT or the like, and is epoxy resin in the present embodiment. Holder electrodes 101 for die bond and wire weld are arranged at regions where each light emitting unit is located on the metal baseboard 100. In a practical application, the number of the holder electrodes 101 is four, and the holder electrodes 101 are set by the metal baseboard 100 through etching or stamping. Each light emitting unit includes RGB LED chips 301 fixed on the metal baseboard as well as keys and lines 302 for connecting the RGB LED chips with the holder electrodes, a protective layer 400 is arranged on the light emitting units, and the holder electrodes relate to an external circuit by pads 102 arranged on the back of the metal baseboard 100. The metal baseboard 100 is directly in contact with a PCB, so that the heat dissipation path is short, and the heat of the chips can be quickly exported. As the number of packaging devices on per unit area of an LED display screen increases, if the density is increased by one level, the amount of generated heat is huge, and the structure of the present invention can discharge the heat very efficiently. On the other hand, the packaging module of the present invention has a plurality of light emitting units, the mounting efficiency of which is improved by N times compared with single beads (N is the number of lights emitting units on the packaging module).

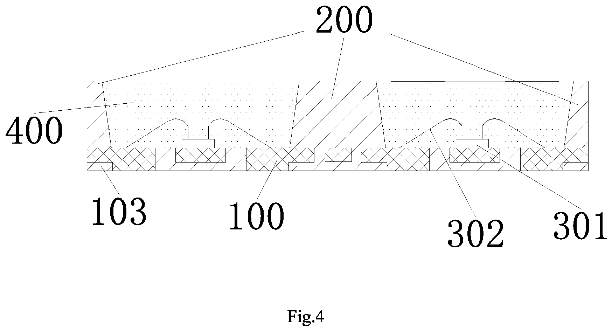

Referring to Figure 4, bowls 201 are set around the light emitting units by the insulating frame 200. Through the arrangement of the bowls 201, the light of RGB LEDs can be more concentrated, and the light emitting surface is unique, so that the influence of other surrounding light emitting units is avoided, and the resolution, light-dark contrast and the like of a manufactured display screen are superior. At the same time, the arrangement of the bowls 201 further enhances the mechanical protection on the light emitting units and avoids the problem of falling of the surface protective layer due to the external force.

In actual production, referring to Figure 4, steps 103 are set on the metal baseboard 100 to reinforce the tightness and stability of combination of the metal baseboard 100 and the insulating frame 200, prevent the ingress of water and water vapor, and further improve the mechanical strength of the module. Preferably, the steps 103 are set on the front side or the reverse side or both the front and reverse sides of the metal baseboard 100. The specific number of the steps 103 is not limited in the present invention.

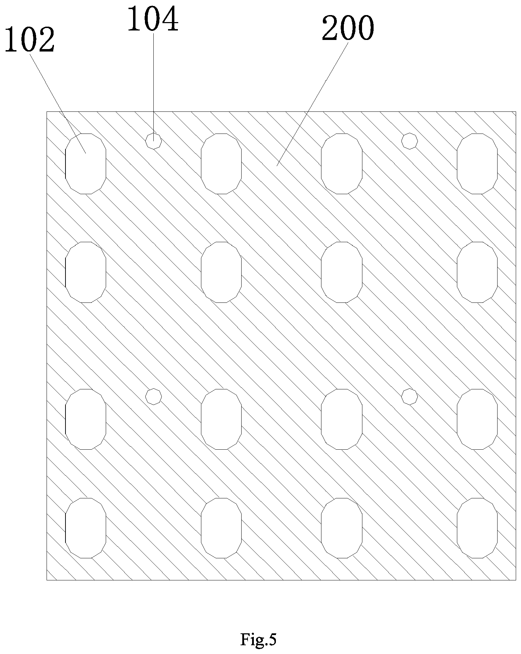

Referring to Figure 5, in actual production, support regions 104, being flush with the pads 102 in height, are further set on the metal baseboard 100. The arrangement of the support regions 104 can ensure the flatness of the metal baseboard 100 during the preparing process of the packaging module and prevent the metal baseboard 100 from being come off or tilting when the insulating frame is die-pressed. Preferably, the support regions 104 may be circular, square or other irregular support regions or support pillars. The number of the support regions 104 may be one or plural, which is not further defined in the present invention.

Referring to Figure 4, preferably, the surface of the protective layer 400 is rough and non-reflective. Further, the protective layer 400 is a translucent epoxy resin layer with a diffusing agent. The protective layer 400 is seamlessly combined with the bowls 201 to further prevent the ingress of water and water vapor, and the waterproof effect is much better than that of conventional metal and plastic bonding. On the other hand, the surface of the protective layer 400 is rough and non-reflective, which reduces the influence of external light. Further, the translucent epoxy resin layer with the diffusing agent is combined with the bowls 201 to form an optical lens, so that the LED light is more concentrated.

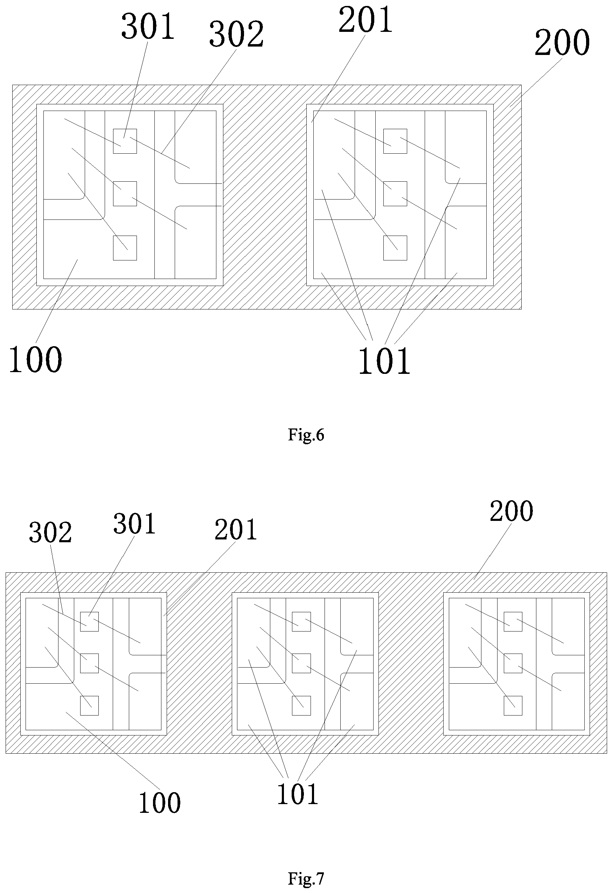

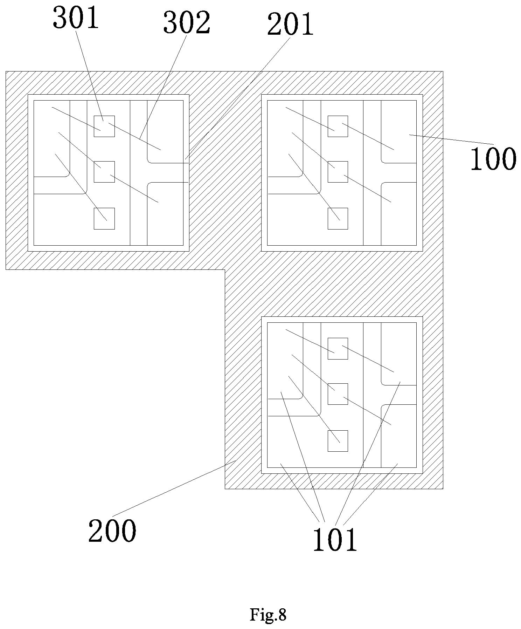

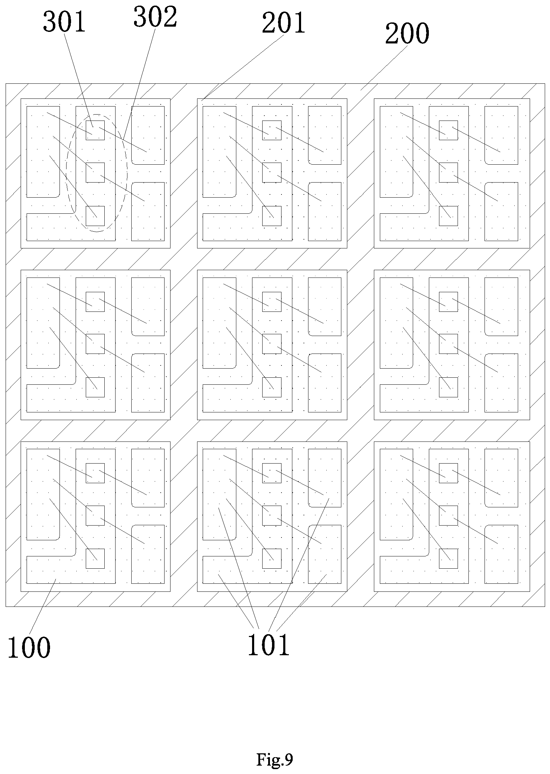

Figure 6 to Figure 9 show embodiments of packaging modules having different numbers of light emitting units according to the present invention. The number of lights emitting units is two in Figure 6, three in Figure 7, and nine in Figure 9. In the present invention, the number of the light emitting units is at least two, preferably 2-16. Referring to Figure 8, the light emitting units may also be arranged in an inverted "L" shape. The arrangement of the light emitting units is not limited in the present invention, and may be an "-" arrangement, or a combination of rows and columns of M×N (M and N are integers), or other irregular arrangement, and the present invention is not limited thereto. It should be noted that modifications or changes could be made by those of ordinary skill in the art according to the above description, and all these modifications or changes shall fall within the scope of the appended claims of the present invention.

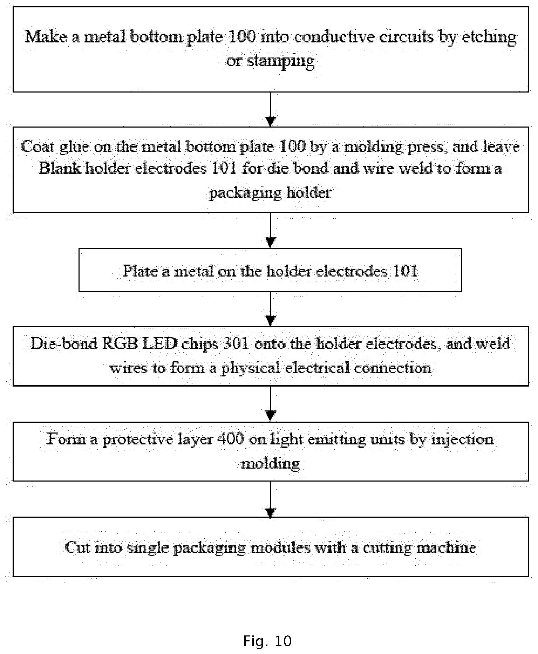

Referring to Figure 10, the present invention also provides a preparing method of the surface-mounted RGB LED packaging module, including the following steps:
step 1: making a metal baseboard 100 into conductive circuits by etching or stamping;
step 2: coating glue on the metal baseboard 100 by a molding press, and leaving blank holder electrodes 101 for die bond and wire weld to form a packaging holder;
step 3: plating a metal on the holder electrodes 101;
step 4: die-bonding RGB LED chips 301 onto the holder electrodes, and welding wires to form a physical electrical connection;
step 5: forming a protective layer 400 on light emitting units by injection molding; and
step 6: cutting into single packaging modules with a cutting machine.

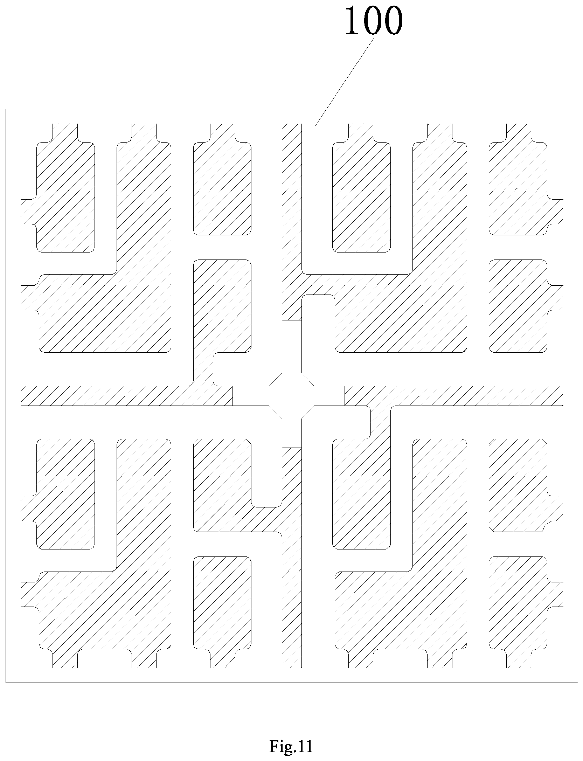

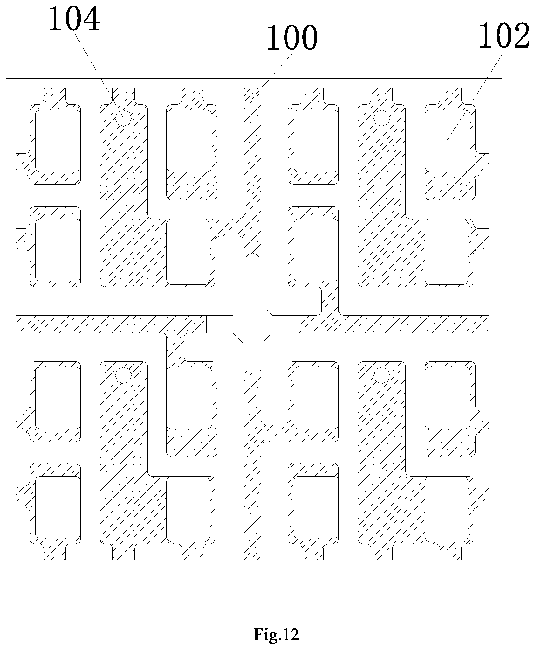

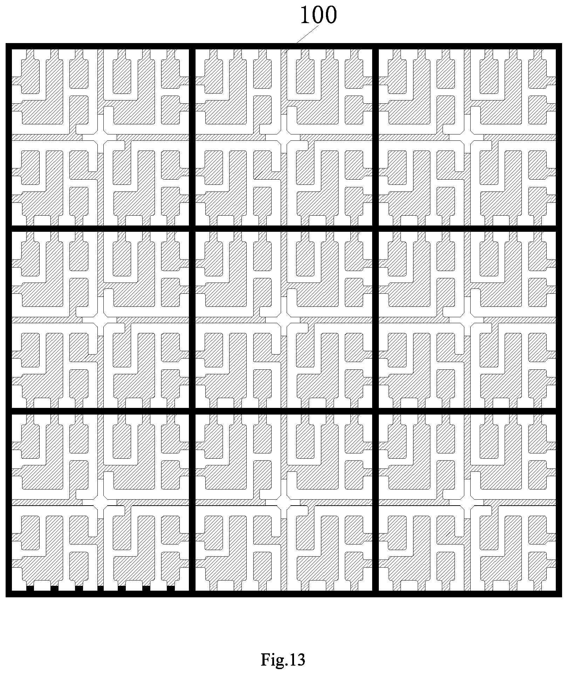

Figure 11 to Figure 13 are structure diagrams of a metal baseboard 100 of a 1×4 packaging module (i.e., one packaging module having four light emitting units) according to the present invention. In actual production, the holder electrodes 101 need to be independent from each other, otherwise, short circuit is caused. If the holder electrodes 101 are to be plated, all the holder electrodes 101 must be connected. In the present invention, the metal baseboard 100 is firstly made into conductive circuits through step 1. At this time, all the holder electrodes 101 are connected. After electroplating of step 3, the metal baseboard 100 is cut with a cutting machine, and all the holder electrodes 101 are disconnected at the joints, thereby solving the above problem. Referring to Figure 13, for the case where the packaging module has different numbers of light emitting units, the joints of all the holder electrodes 101 can be set at the cutting positions of the cutting machine, to ensure that the joints of all the holder electrodes 101 are cut off during cutting. It should be noted that the connection direction of the holder electrodes 101 and the specific shape and circuits etched or stamped on the metal baseboard 100 are not limited in the present invention, modifications or changes could be made by those of ordinary skill in the art according to the above description, and all these modifications or changes shall fall within the scope of the appended claims of the present invention.

In a practical application, step 1 may further include setting steps 103 on the front side and/or the reverse side of the metal baseboard 100. Further, step 1 further includes setting support regions 104, being flush with the pads 102 in height, on the back of the metal baseboard 100.

In actual production, step 2 includes setting a plurality of bowls 201 on the metal baseboard 100 during die pressing. Through the arrangement of the bowls 201, the light of RGB LEDs can be more concentrated, and the light emitting surface is unique, so that the influence of other surrounding light emitting units is avoided, and the resolution, light-dark contrast and the like of a manufactured display screen are superior. At the same time, the arrangement of the bowls 201 further enhances the mechanical protection on the light emitting units and avoids the problem of falling of the surface protective layer due to the external force.

In actual production, the injection-molding method of the protective layer 400 in step 5 may be injecting liquid glue into the cavities of the bowls 201 by means of dispensing or filling. Preferably, a translucent epoxy resin glue with a diffusing agent is selected and cured by heating preferably at 100-300 degrees Celsius. In this way, a full bowl protective layer is set. The protective layer 400 is flush with the bowls 201 in height, the height of the bowls 201 is 0.5-0.7 mm, and the protective layer 400 made in this way is more stable.

The glue injection method may also be pressing the glue into the cavities of the bowls 201 through a designed MGP mold, and the glue is liquid glue or solid glue cakes. In this way, a half bowl protective layer is set, the bowls 201 are slightly lower than the protective layer 400 in height, the height of the bowls 201 is 0.3-0.5 mm, and the protective layer supported in this way is low in cost.

In the present invention, the metal baseboard is used to replace conventional plated thin metal, thereby enhancing the conductivity; the metal baseboard is directly in contact with a PCB, so the heat dissipation path is short, and the heat of the chips can be quickly exported; light is concentrated by setting the bowl-type structures on the front side, so that the light emitting surface is unique, and the resolution, light-dark contrast and the like of a manufactured display screen are superior; steps are set on the metal baseboard to ensure a tight combination with the insulating frame and the stability of the packaging holder; and the plurality of light emitting units is integrated on one packaging module to further improve the production efficiency and reduce the production cost.

It should be understood that the application of the present invention is not limited to the above examples, modifications or changes may be made by those of ordinary skill in the art according to the above description, and all these modifications and changes shall fall within the scope of the appended claims of the present invention.

## Claims

1. A QFN surface-mounted RGB LED packaging module, wherein comprising a packaging holder and light emitting units arranged on the packaging holder; the number of the light emitting units is at least two, the packaging holder comprises a metal baseboard and an insulating frame; holder electrodes for die bond and wire weld are arranged on the metal baseboard at regions where each light emitting unit is located, each light emitting unit comprises RGB LED chips fixed on the metal baseboard as well as keys and wires for connecting the RGB LED chips with the holder electrodes; a protective layer is arranged on the light emitting units, and the holder electrodes are connected with an external circuit by pads arranged on the back of the metal baseboard.

2. The QFN surface-mounted RGB LED packaging module according to claim 1, wherein the insulating frame are arranged around the light emitting units and forms bowl shape.

3. The QFN surface-mounted RGB LED packaging module according to claim 1, wherein steps are set on the front side and/or the reverse side of the metal baseboard.

4. The QFN surface-mounted RGB LED packaging module according to claim 1, wherein support regions, being flush with the pads in height, are further set on the metal baseboard.

5. The QFN surface-mounted RGB LED packaging module according to claim 1, wherein the surface of the protective layer is rough and non-reflective.

6. A method for preparing the QFN surface-mounted RGB LED packaging module according to claims 1-5, comprising the following steps:
step 1: making a metal baseboard into conductive circuits;
step 2: coating glue on the metal baseboard, and leaving blank holder electrodes for die bond and wire weld to form a packaging holder;
step 3: plating a metal on the holder electrodes;
step 4: die-bonding RGB LED chips onto the holder electrodes, and welding wires to form a physical electrical connection;
step 5: forming a protective layer on light emitting units by injection molding; and
step 6: cutting into single packaging modules.

7. The method for preparing the QFN surface-mounted RGB LED packaging module according to claim 6, wherein step 1 further comprises setting steps on the front side and/or the reverse side of the metal baseboard.

8. The method for preparing the QFN surface-mounted RGB LED packaging module according to claim 6, wherein step 1 further comprises setting support regions, being flush with pads in height, on the back of the metal baseboard.

9. The method for preparing the QFN surface-mounted RGB LED packaging module according to claim 6, wherein step 2 comprises setting a plurality of bowls on the metal baseboard during die pressing.

10. The method for preparing the QFN surface-mount RGB LED packaging module according to claim 9, wherein the injection-molding method of the protective layer in step 5 comprises: injecting glue into bowl cavities by dispensing or filling, and then curing the glue by heating; or pressing the glue into the bowl cavities through an MGP mold, the glue being liquid glue or solid glue cakes.
